# EUROPEAN PATENT APPLICATION

(11) **EP 3 418 041 A1**
(43) Date of publication of application: **26.12.2018**
(21) Application number: 17176763.5
(22) Date of filing: 20.06.2017
(51) Int. Cl.: B29D 11/00, B82Y 20/00, C09D 11/101, G02F 1/1335, G02B 3/00, G02B 3/02, H01L 33/02, H01L 33/50, B33Y 10/00, B29C 64/112

(54) **QUANTUM DOT LENS, DEVICES COMPRISING THE SAME, AND METHOD OF MANUFACTURING A QUANTUM DOT LENS**

(71) Applicant: Vestel Elektronik Sanayi ve Ticaret A.S., 45030 Manisa (TR)
(72) Inventor: ELIBOL, Metehan, 45030 Manisa (TR); ÖZAYDIN, Mustafa Caglar, 45030 Manisa (TR); KARSLI, Kivanc, 45030 Manisa (TR)
(74) Representative: Ascherl, Andreas

(57) **Abstract**

The present invention provides a lens (5) at least comprising a solidified droplet of a transparent liquid doped with quantum dots (6), wherein the quantum dots transmit (4) visible light of a longer wavelength than they receive (3). The transparent liquid can be used to manufacture the lens in an inkjet material deposition process, whereby the lens can be provided with any shape as desired, and the design of the lens may also be quickly and easily changed during the manufacturing process with little cost or delay. The quantum dots with which the transparent liquid is doped can be used to down-convert the wavelength of light transmitted through the lens, and the shape, size, composition and concentration of the quantum dots may also be quickly and easily altered to modify the optical properties of the lens, and in particular to modify the colour gamut of light transmitted by the lens. The lens (5) may be a component part of a light emitting electronic device further comprising an LED (2), mounted on a substrate (1). The LED may, for example, be a blue LED and the quantum dots (6) may have a size distribution comprising two peaks configured to transmit light at green and red wavelengths, so that light (3) from the LED (2) is down-converted by the quantum dots (6) into light of longer wavelengths and mixes with the blue light (3) from the LED to provide white light (4) with a high colour gamut. Furthermore, a plurality of such LED devices may be incorporated into a backlight for a display, such as a video display screen. This has the advantages of providing the display with more even illumination and a wider colour gamut of light transmitted by the lens than previously. The present invention also provides a method of manufacturing a lens, wherein the method comprises doping a transparent liquid with quantum dots which transmit visible light of a longer wavelength than they receive, spraying the liquid as droplets from a nozzle of an inkjet printer onto a substrate, and curing the liquid to solidify the droplets.

## Description

The present invention relates to a lens according to claim 1, a light emitting electronic device according to claim 8, a backlight for a display screen according to claim 11, and a method of manufacturing a lens according to claim 12.

### Background of the Invention

It is known to provide display screens, such as video display screens, with backlights to enhance their brightness. Such backlights generally comprise a plurality of light emitting electronic devices, which themselves each comprise a light emitting diode (LED) and associated optics, such as a total internal reflection (TIR) lens. However, such traditional backlights suffer from several problems, as follows: uneven illumination of the display, inflexibility of their manufacturing process to adapt the design of the optics, and low colour gamut of the light they produce.

Technical background to the present invention may be found in H. Haverinen: "Inkjet-Printed Quantum Dot Hybrid Light-Emitting Devices - Towards Display Applications", Acta Universitiatis Ouluensis, C. Technica 351, University of Oulu, Oulu (2010).

### Object of the Invention

It is therefore an object of the invention to provide a lens, a light emitting electronic device, a backlight for a display screen, and a method of manufacturing a lens.

### Description of the Invention

The object of the invention is solved by a lens according to claim 1. The lens at least comprises a solidified droplet of a transparent liquid doped with quantum dots, wherein the quantum dots transmit visible light of a longer wavelength than they receive.

This solution is beneficial because the transparent liquid can be used to manufacture the lens in an inkjet material deposition process, whereby the lens can be provided with any shape as desired, and the design of the lens may also be quickly and easily changed during the manufacturing process with little cost or delay. The quantum dots with which the transparent liquid is doped can be used to down-convert the wavelength of light transmitted through the lens, and the shape, size, composition and concentration of the quantum dots may also be quickly and easily altered to modify the optical properties of the lens, and in particular to modify the colour gamut of light transmitted by the lens.

Advantageous embodiments of the invention may be configured according to any claim and/or part of the following description.

In one possible preferred embodiment, the lens is a microlens comprising a single such solidified droplet of transparent liquid doped with quantum dots. This solution is beneficial because such a microlens can have several different applications in nanotechnology.

However, in an alternative possible embodiment, the lens at least comprises a plurality of such solidified droplets fused together, for example by curing them with ultraviolet light. This solution is beneficial because it allows a lens of any shape to be formed by the accumulation of such droplets in layers in an inkjet material deposition process.

Preferably, the distribution of the quantum dots within the lens is homogeneous. This helps to provide the lens with homogeneous and isotropic optical properties. However, for certain applications, such as for a graded index (GRIN) lens, the distribution of the quantum dots within the lens may be rendered inhomogeneous by altering their concentration during manufacture.

If the lens at least comprises a plurality of solidified droplets fused together, in possible embodiments, the lens may at least comprise solidified droplets of a plurality of different liquids, at least one of which is the transparent liquid doped with quantum dots. In this way, the lens may for example be provided with an optical coating of a different material.

In a preferred embodiment, the quantum dots are of a uniform size. This solution is beneficial because it can be used to create a spectral distribution of light transmitted by the lens having a narrow and well-defined emission peak determined by the size of the quantum dots.

In an alternative possible preferred embodiment, the quantum dots may have a size distribution comprising at least two peaks. This solution is beneficial because it can be used to create a spectral distribution of light transmitted by the lens having a plurality of emission peaks, each of which corresponds to one of the peaks in the size distribution of the quantum dots.

The present invention also relates to a light emitting electronic device at least comprising a light-emitting diode (LED) and a lens as described herein. Preferably, the LED is a blue LED and the quantum dots have a size distribution comprising at least two peaks configured to transmit light at green and red wavelengths. This solution is beneficial because the blue light emitted by the LED can be down-converted by the quantum dots within the lens to provide green and red light, which mix with the blue light from the LED to provide white light with a high colour gamut. The LED may be encapsulated within the lens.

In one possible preferred embodiment, the light emitting electronic device comprises at least two such lenses having a different shape from each other or a different composition of quantum dots from each other, or both. In this way, for example, light emitting electronic devices with doublet and triplet lens or with complex optical properties may be produced.

The present invention further relates to a backlight for a display screen, such as a video display screen or a static poster display, at least comprising a plurality of light emitting electronic devices as described herein.

In addition, the present invention relates to a method of manufacturing a lens. The method at least comprises doping a transparent liquid with quantum dots which transmit visible light of a longer wavelength than they receive, spraying the liquid as droplets from a nozzle of an inkjet printer onto a substrate, and curing the liquid to solidify the droplets.

This solution is beneficial because lenses of any shape or design and with a wide range of optical properties may be quickly and easily manufactured thereby, and the design of the lens may be changed without interrupting the manufacturing process.

After manufacture of the lens as described, the cured and solidified liquid may either be retained on the substrate as part of an integrated structure, for example if the substrate is a printed circuit board, or the lens may be released from the substrate for incorporation into another device as a component thereof.

Preferably, the method further comprises designing a shape of the lens, and depositing the droplets onto the substrate in layers in the shape of the lens as designed. This solution is beneficial because it allows lenses of complex designs composed of a plurality of droplets to be produced by an inkjet material deposition process, in addition to microlenses each made from an individual droplet.

In a possible preferred embodiment, the method further comprises mounting an LED on the substrate, and encapsulating the LED within the lens. In this manner, an integrated light emitting device comprising an LED and its associated optics may be manufactured.

In various possible different embodiments, the method further comprises varying one or more of the size, shape, composition and concentration of the quantum dots within the liquid during spraying. This has the advantage of allowing the optical properties of the lens to be varied during manufacture.

The present invention further relates to a computer program product or a program code or system for executing one or more than one of the herein described methods.

Further features, goals and advantages of the present invention will now be described in association with the accompanying drawings, in which exemplary components of the invention are illustrated. Components of the devices and methods according to the invention which are at least essentially equivalent to each other with respect to their function can be marked by the same reference numerals, wherein such components do not have to be marked or described in all of the drawings.

In the following description, the invention is described by way of example only with respect to the accompanying drawings.

### Brief Description of the Drawings

Fig. 1A is a close-up photograph of part of an edge-type backlight illumination strip of the prior art mounted in an enclosure for a video display screen;
Fig. 1B is a schematic diagram of a first possible location of the edge-type backlight illumination strip of Fig. 1A in an enclosure for a video display screen;
Fig. 1C is a schematic diagram of a second possible location of the edge-type backlight illumination strip of Fig. 1A in an enclosure for a video display screen;
Fig. 2A is a photograph from the rear of a back panel of an enclosure for a direct-type of backlight illumination unit of the prior art;
Fig. 2B is a schematic diagram of a direct-type of backlight illumination unit of the prior art for a video display screen;
Fig. 3A is a first photograph showing a plan view of a total internal reflection optical element of the prior art;
Fig. 3B is a second photograph showing a perspective view of the total internal reflection optical element shown in Fig. 3A;
Fig. 4 is a schematic diagram showing a cross-sectional view of a total internal reflection optical element of the prior art;
Fig. 5A is a photograph of two halves of a mould used in the manufacture of several total internal reflection optical elements of the type shown in Figs 3A, 3B and 4;
Fig. 5B is a photograph of several total internal reflection optical elements of the prior art after their release from a mould such as that shown in Fig. 5A;
Fig. 6 is a graph showing the angular distribution of light transmitted by a total internal reflection optical element of the type shown in Figs. 3A to 5B;
Fig. 7A is a photograph from the rear of a back panel of an enclosure of a video display screen of the prior art, showing angles of elements of the back panel;
Fig. 7B is a photograph of a video display screen showing a typical example of its illumination by a direct-type of backlight illumination;
Fig. 8A is a CIE 1931 colour chart showing the typical colour values of white light emitted by an LED of the prior art;
Fig. 8B is a graph showing a typical example of the spectral distribution of white light emitted by an LED of the prior art;
Fig. 9 is a graph showing how the spectral distribution of white light emitted by an LED of the prior art may by modified by a K₂SiF₆ phosphor;
Fig. 10A is a photograph of a first example of a droplet formed by inkjet printing;
Fig. 10B is a photograph of a second example of a droplet formed by inkjet printing;
Fig. 11 is a graph showing the normalized emission intensity of five quantum dots of different sizes;
Fig. 12 is a schematic diagram of a method of manufacturing a quantum dot lens according to an embodiment of the invention;
Fig. 13 is a schematic perspective view of a light emitting electronic device according to an embodiment of the invention; and
Fig. 14 is a graph showing a typical example of the spectral distribution of light transmitted by a quantum dot lens according to an embodiment of the invention.

### Detailed Description of the Drawings

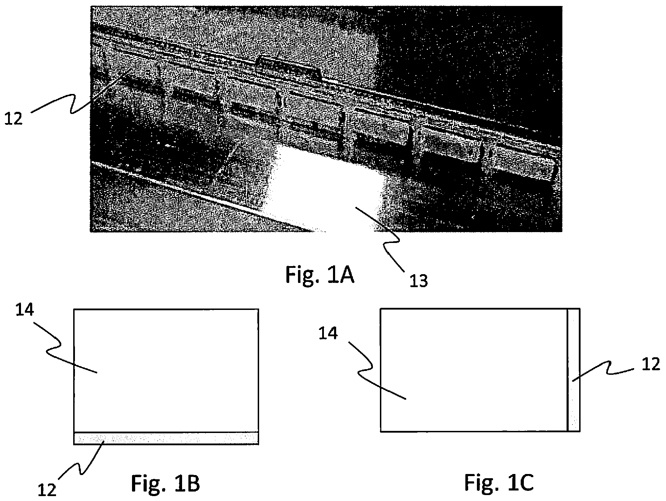

Fig. 1A is a close-up photograph of part of an edge-type backlight illumination strip 12 of the prior art mounted in an enclosure 13 for a video display screen 14. Such an edge-type backlight illumination strip 12 comprises a plurality of light emitting electronic devices, which are typically light emitting diodes (LEDs), together with their associated optics. The backlight illumination strip 12 may be mounted within the display screen enclosure 13 either along a horizontal edge thereof, as shown in Fig. 1B, or along a vertical edge thereof, as shown in Fig. 1C, or a combination of both. This edge type of backlight illumination has the disadvantage that light injected at the edge of the display screen must be guided in a complicated manner to try and ensure evenly distributed illumination of the display screen from its edges all the way to the centre of the display screen, which requires very sophisticated design and manufacturing techniques, which are not always possible. Corners or edges of the screen can therefore appear brighter than the centre thereof.

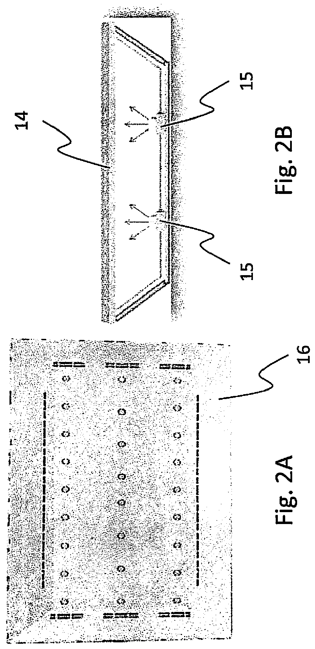

Fig. 2A is a photograph from the rear of a back panel 16 of an enclosure for a direct-type of backlight illumination unit. As may be seen from Fig. 2A, the back panel 16 is sufficiently deep to allow a direct-type of backlight illumination unit of the type shown in Fig. 2B to be mounted therein behind a video display screen. This direct-type of backlight illumination comprises one or more light-emitting electronic devices 15, such as light emitting diodes (LEDs), and their associated optics, which are oriented to direct light onto the rear of the video display screen 14, instead of at its edges.

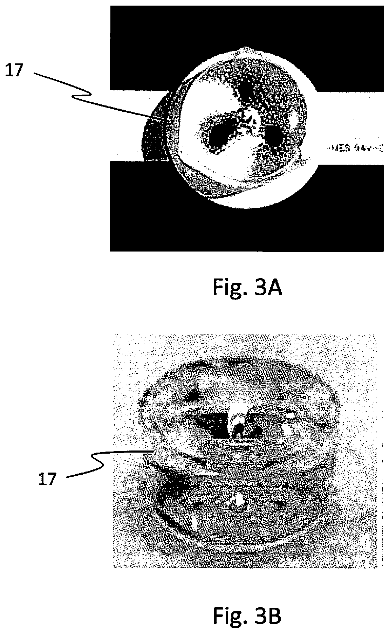

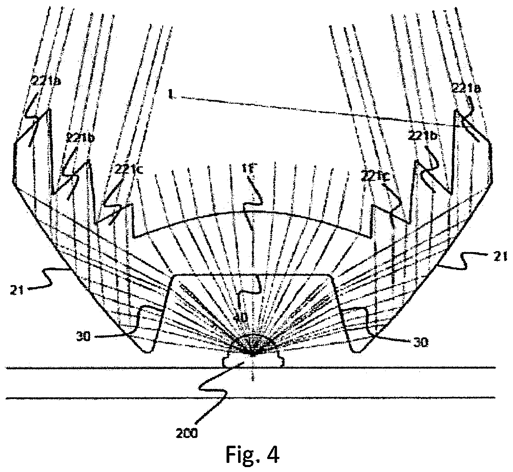

Figs. 3A and 3B are two photographs of a total internal reflection (TIR) optical element 17 which is an optic of the type used in the prior art in such a direct-type light-emitting electronic device 15, in association with an LED. Fig. 4 schematically shows a cross-sectional view of such a TIR optical element 17, as described in EP 2 835 575 A, for the purposes of illustrating how such a TIR optical element 17 works. Light emitted by LED 200 enters the TIR optical element 17 through central refractive surface 30 and lateral refractive surfaces 40. Whereas rays of light from the LED 200 emitted in the direction of optical axis 11 pass straight through the optical element 17, other rays of light are refracted by the central and lateral refractive surfaces 30, 40 as shown in Fig. 4 and are subject to total internal reflection from reflective surfaces 21, before exiting the optical element 17 via steps of a Fresnel zone plate 221a, 221b, 221c. The light from LED 200 is thus redirected in a range of angles as desired.

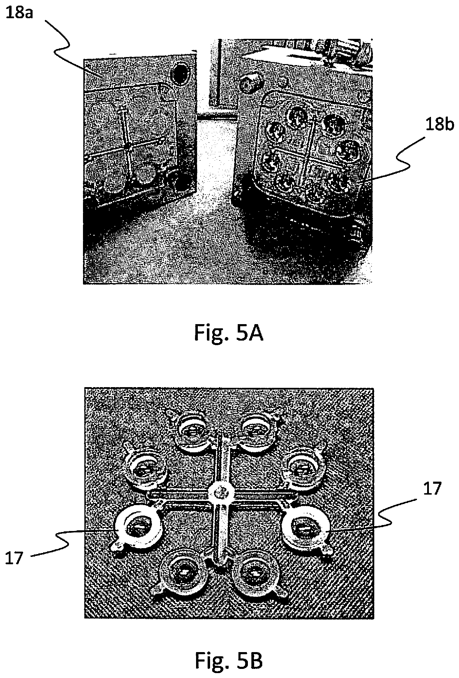

Fig. 5A is a photograph of two halves 18a, 18b of a mould which may be used to manufacture several TIR optical elements 17 of the type shown in Figs 3A, 3B and 4. Such lens moulds may be acquired, for example, from Darkoo Optics (Zhongshan) Co., Ltd. of Zhongshan City, Guangdong, China with model number DK4224-JC. The mould may be injected with a transparent plastics material, such as poly(methyl methacrylate) (PMMA), to produce a moulding comprising a plurality of such TIR optical elements 17 joined together by webbing, as shown in Fig. 5B. The TIR optical elements 17 may then be separated from the webbing for subsequent use. Such a manufacturing technique has the disadvantage that once the shape of the lens has been designed and the moulds created, the shape of the lens cannot be quickly and easily changed, without making new moulds. Moulding of this type is also inherently a batch production process, producing one batch of lens from each moulding operation, which is slower than a continuous production process.

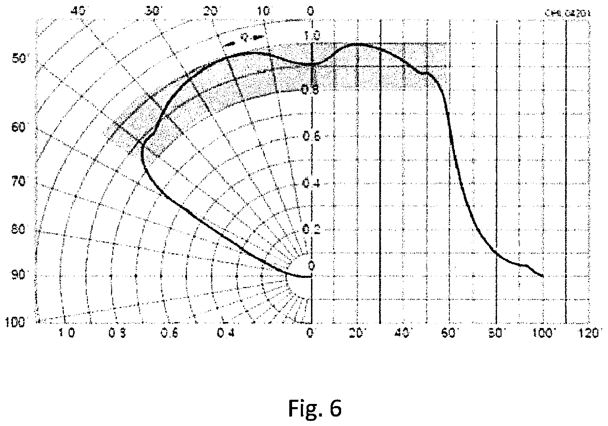

Fig. 6 is a graph showing the angular distribution of light transmitted by a TIR optical element 17 of the type shown in Figs. 3A to 5B, plotted in polar co-ordinates on the lefthand side of Fig. 6 and in linear co-ordinates on the right-hand side of Fig. 6. As may be seen, the angular distribution of light transmitted by the TIR optical element 17 covers a range of from zero up to about 55 degrees, as highlighted in Fig. 6 by the shaded zone of the graph, before falling off rapidly.

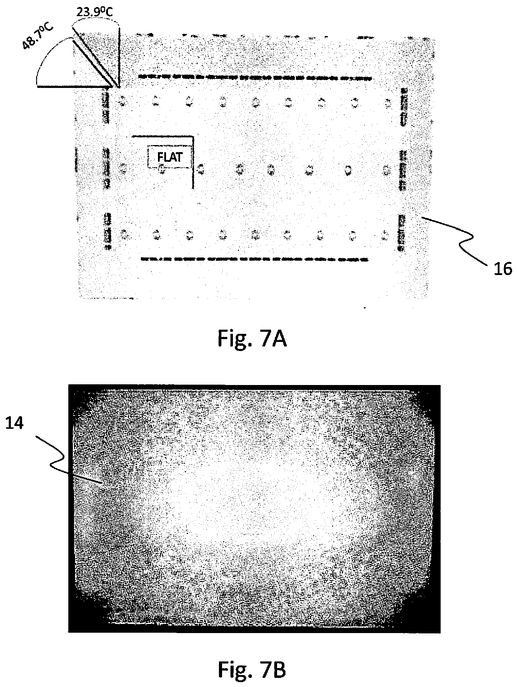

Fig. 7A is a photograph again showing the rear of the back panel 16 of an enclosure for a video display screen, but now marked with angles of elements of the back panel 16 as indicated in Fig. 7A. The combination of these angles with the angular distribution of light transmitted by a TIR optical element 17 as shown in Fig. 6 is used in the direct type of backlight illumination of the prior art to try and illuminate the video display screen more evenly than edge-type backlight illumination. However, even with such direct-type backlighting, illumination of the display screen can remain very uneven, as shown by the photograph of Fig. 7B.

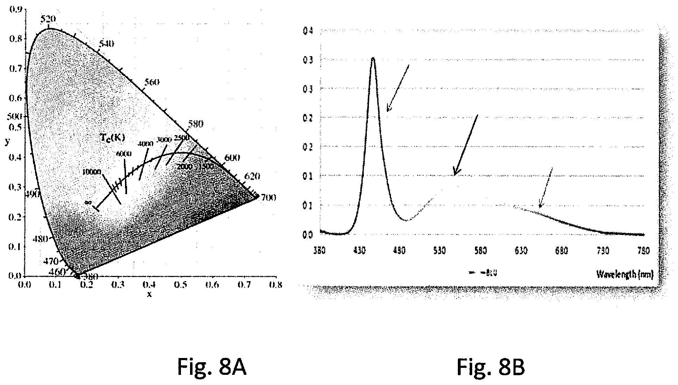

Fig. 8A is an International Commission on Illumination (CIE) 1931 colour chart showing the typical colour values of white light emitted by an example LED of the prior art. The emitted light has Cx and Cy colour values, which give a colour temperature of about 9300 K, as an example. This corresponds to a typical spectral distribution as represented in the graph of Fig. 8B. The spectral distribution has one larger, narrower emission peak and two lower, broader emission peaks at the wavelengths indicated in Fig. 8B by the arrows, which roughly correspond to the wavelengths of blue, green and red light, respectively. The gamut value of this spectral distribution is 72% CIE 1931. Transmitting light with this spectral distribution through a lens of the type shown in Figs 3A, 3B and 4 does not change this gamut value at all.

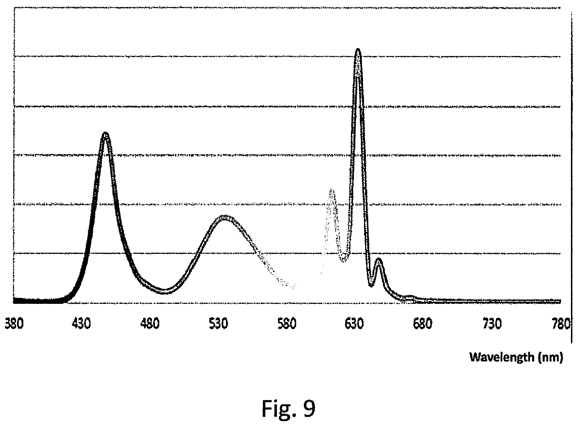

Fig. 9 is a graph showing how the spectral distribution of white light emitted by an LED of the type shown in Figs. 8A and 8B may by modified by a K₂SiF₆ phosphor (also known as a KSF phosphor). An example of such a KSF phosphor is described in US 2012/0299466. The KSF phosphor can increase the height of the longest wavelength (red) emission peak relative to that of the other two peaks as shown in Fig. 9, and can therefore also increase the gamut value achievable up to about 90% CIE 1931. However, the overall spectral distribution still remains somewhat uneven, and a gamut value of 100% remains unachieved.

In summary, therefore, the different display backlighting techniques of the prior art suffer from several drawbacks as follows: uneven display illumination, an insufficiently high colour gamut value, and inflexible and costly manufacturing techniques.

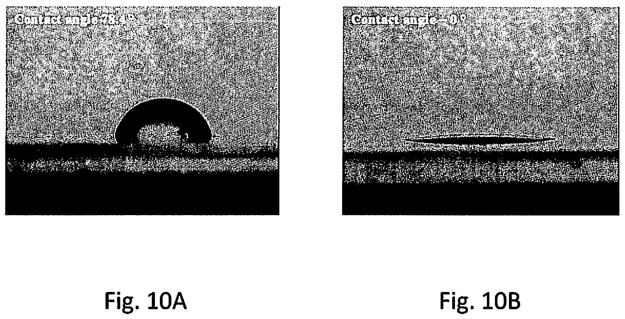

Figs. 10A and 10B are photographs showing two examples of droplets formed on a substrate by inkjet printing, reproduced from H. Haverinen: "Inkjet-Printed Quantum Dot Hybrid Light-Emitting Devices - Towards Display Applications", Acta Universitiatis Ouluensis, C. Technica 351, University of Oulu, Oulu (2010). The droplet shown in Fig. 10A has a contact angle with the substrate of 78.4 degrees, whereas the droplet shown in Fig. 10B has a contact angle with the substrate of substantially zero degrees. The contact angle, as well as the size of the droplets, may be varied by altering the viscosity of the ink, as well as the velocity and output pressure with which the droplets are sprayed.

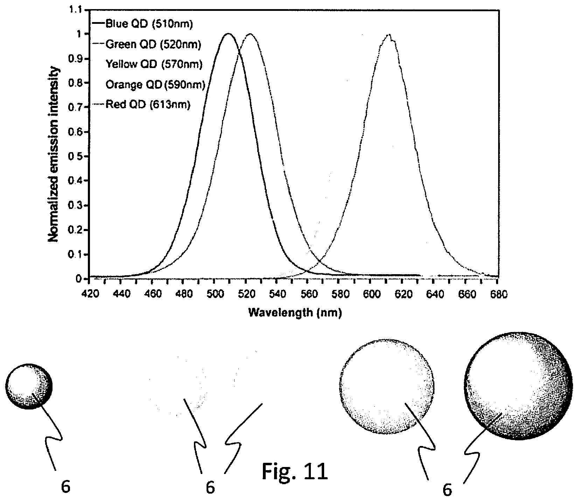

Fig. 11 is a graph showing the normalized emission intensity of five quantum dots of different sizes. A quantum dot is a nanoscale particle whose physical properties vary according to their size and shape. Thus the optical properties of a quantum dot, including the wavelength at which it transmits light, can be varied by altering its size and shape. Fig. 11 therefore shows how larger quantum dots emit light of longer wavelengths than smaller ones, and gives examples of emission peaks at five different wavelengths for differently sized quantum dots.

According to the invention, quantum dots of the type shown in Fig. 11 may be suspended in a transparent liquid, and the liquid may be sprayed from an inkjet printer onto a substrate to create droplets of the type shown in Fig. 10. One or more of these droplets may be used in an inkjet material deposition process, in order to produce a lens.

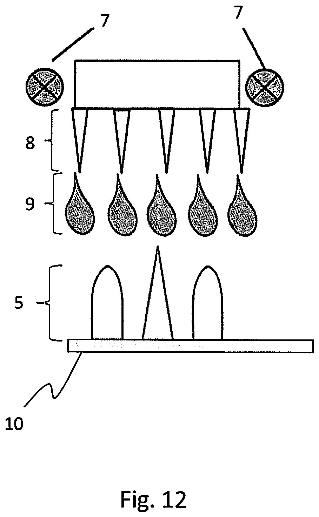

Fig. 12 therefore schematically shows an embodiment of a method of manufacturing a lens. Once the transparent liquid has been doped with quantum dots which transmit visible light of a longer wavelength than they receive, droplets 9 of the liquid are sprayed from one or more nozzles 8 of an inkjet printer onto a substrate 10. The doped liquid deposited on the substrate 10 is cured by ultraviolet light emitted by UV lights 7, in order to solidify it. A single droplet of the transparent liquid may be cured to make a microlens, or a plurality of such droplets may be accumulated in layers and fused together by such UV curing to create a larger lens of any shape. The shape of the lens may be designed in advance and the droplets deposited onto the substrate 10 in layers in the shape of the lens as designed, to create the shape desired, which may vary according to requirements, as represented in Fig. 12 by the differently shaped lenses 5. Since the inkjet material deposition process is continuous, it is quicker than the batch lens moulding process described above in relation to Figs. 5A and 5B, and the shape of the lens or lenses which are produced may easily be changed by redesigning them without the need to make any new moulds.

The properties of the lens or lenses produced may be varied between lenses or even within one lens by varying the viscosity of the transparent liquid, and the velocity and pressure at which the liquid is sprayed. The distribution of the quantum dots within the lens may be homogeneous or it may be rendered inhomogeneous by varying the concentration of the quantum dots within the liquid during the spraying process.

The transparent liquid doped with quantum dots may be combined with one or more other liquids during the spraying process to produce a lens with more complex properties. For example, the lens may be provided with a coating by being sprayed with another liquid having a different composition. In another example, two or more layers of different optical properties may be deposited to make a doublet or triplet lens.

The quantum dots used to dope the transparent liquid may all be of a uniform size, to give a single peak emission wavelength, or they may be of two of more different shapes or sizes to give a spectral distribution correspondingly having two or more emission peaks.

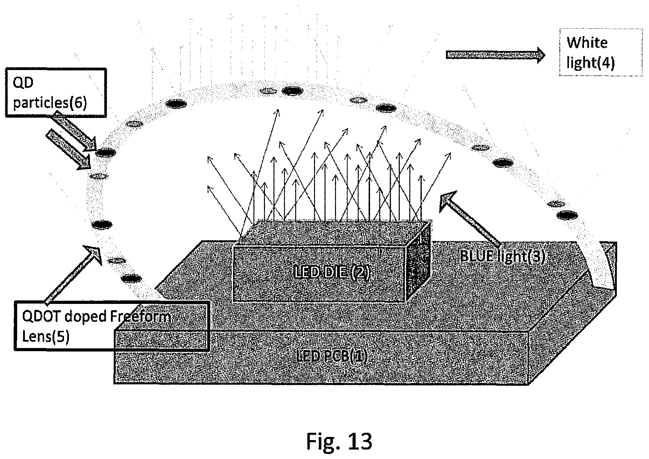

Fig. 13 schematically shows an embodiment of a light emitting electronic device. The light emitting electronic device comprises an LED die 2 mounted on a printed circuit board 1, onto which a lens 5 doped with quantum dots 6 has been deposited using the technique as described above in relation to Fig. 12. The LED die 2 is a blue LED, which therefore emits blue light 3. The quantum dots 6 have a size distribution comprising two peaks configured to transmit light at green and red wavelengths. The blue light 3 therefore enters the encapsulating lens 5, where it is down-converted and re-emitted as light of longer wavelengths by the quantum dots 6 within the lens 5 to provide green and red light. These mix with the blue light 3 from the LED to create white light 4 with a high colour gamut.

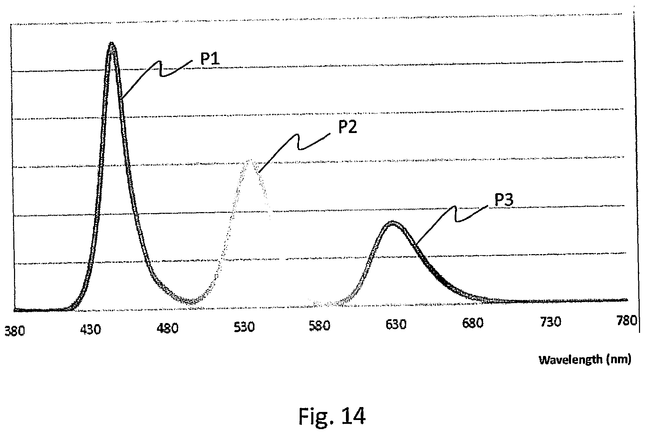

Fig. 14 is a graph showing how the spectral distribution of the blue light 3 emitted by the LED 2 in the light emitting electronic device of Fig. 13 is transmitted by the quantum dot-doped lens 5. In comparison to those shown in Figs. 8B and 9, the spectral distribution of the light transmitted by the quantum dot-doped lens 5 has three distinct and well-defined emission peaks, P1, P2, P3. The emission peak P1 is the blue light 3 emitted by the LED die 2 itself, whereas the emission peaks P2 and P3 are those created by the quantum dots 6 in the lens 5. These can all be finely adjusted by tuning the wavelength of the LED 2 and by varying the size, shape, composition and concentration of the quantum dots 6 to correspond exactly to the desired wavelengths of blue, green and red light, respectively. The gamut value of this spectral distribution is therefore 98.2% CIE 1931, which is significantly greater than that which can be achieved with a traditional white LED and a KSF phosphor, as shown, for example, in Fig. 9. Moreover, since the quantum dot-doped lens 5 can be manufactured with any shape as desired, and the shape can be redesigned and altered quickly and easily, a plurality of such lenses with different sizes, shapes, compositions and/or concentrations of quantum dots from each other may easily be created within the same manufacturing run and incorporated into the same or several different light emitting electronic devices.

A plurality of such light emitting electronic devices as described above may also be used as component parts of a backlight for a display screen, such as a video display screen or a static advertising poster display. Since the lenses of the light emitting electronic devices in the backlight can be easily and cheaply provided with a range of different shapes, the light they transmit can be directed as desired, and the problems with uneven illumination of the display screen described above in relation to Figs. 6 to 7B can thereby also be greatly reduced or eliminated entirely.

In summary, therefore, the present invention provides a lens at least comprising a solidified droplet of a transparent liquid doped with quantum dots, wherein the quantum dots transmit visible light of a longer wavelength than they receive. The transparent liquid can be used to manufacture the lens in an inkjet material deposition process, whereby the lens can be provided with any shape as desired, and the design of the lens may also be quickly and easily changed during the manufacturing process with little cost or delay. The quantum dots with which the transparent liquid is doped can be used to down-convert the wavelength of light transmitted through the lens, and the shape, size, composition and concentration of the quantum dots may also be quickly and easily altered to modify the optical properties of the lens, and in particular to modify the colour gamut of light transmitted by the lens. The lens may be a component part of a light emitting electronic device further comprising an LED, mounted on a substrate. The LED may, for example, be a blue LED and the quantum dots may have a size distribution comprising two peaks configured to transmit light at green and red wavelengths, so that light from the LED is down-converted by the quantum dots into light of longer wavelengths and mixes with the blue light from the LED to provide white light with a high colour gamut. Furthermore, a plurality of such LED devices may be incorporated into a backlight for a display, such as a video display screen. This has the advantages of providing the display with more even illumination and a wider colour gamut of light transmitted by the lens than previously. The present invention also provides a method of manufacturing a lens, wherein the method comprises doping a transparent liquid with quantum dots which transmit visible light of a longer wavelength than they receive, spraying the liquid as droplets from a nozzle of an inkjet printer onto a substrate, and curing the liquid to solidify the droplets.

**Reference Numerals:**

| | | | |
|---|---|---|---|
| 1 | Printed circuit board | 15 | Direct-type backlight light-emitting device |
| 2 | LED die | 16 | Rear panel of video display screen enclosure |
| 3 | Blue light emitted by LED die | | |
| 4 | White light | 17 | LED lens |
| 5 | 3D-printed lens doped with quantum dots | 18a, 18b | Two halves of mould |
| 6 | Quantum dots | 21 | Reflective surface |
| 7 | UV curing lights | 30 | Central refractive surface |
| 8 | Nozzles of inkjet printer | 40 | Lateral refractive surface |
| 9 | Droplets doped with quantum dots | 200 | LED |
| 10 | Substrate | 221a, 221b, 221c | Steps of Fresnel zone plate |
| 11 | Optical axis | | |
| 12 | Edge-type backlight strip | P1, P2, P3 | Emission peaks |
| 13 | Enclosure of video display screen | | |
| 14 | Video display screen | | |

## Claims

1. A lens (5) at least comprising a solidified droplet of a transparent liquid doped with quantum dots (6), wherein the quantum dots transmit visible light of a longer wavelength than they receive.

2. A lens according to claim 1, wherein the lens (5) is a microlens comprising a single such solidified droplet of transparent liquid doped with quantum dots.

3. A lens according to claim 1, wherein the lens (5) at least comprises a plurality of such solidified droplets fused together.

4. A lens according to any one of the preceding claims, wherein the distribution of the quantum dots (6) within the lens (5) is homogeneous.

5. A lens according to claim 3, wherein the lens (5) at least comprises solidified droplets of a plurality of different liquids, at least one of which is the transparent liquid doped with quantum dots.

6. A lens according to any one of the preceding claims, wherein the quantum dots (6) are of a uniform size.

7. A lens according to any one of claims 1 to 5, wherein the quantum dots (6) have a size distribution comprising at least two peaks.

8. A light emitting electronic device at least comprising an LED (2) and a lens (5) according to any one of the preceding claims.

9. A light emitting electronic device according to claim 8, wherein the LED (2) is a blue LED and the quantum dots (6) have a size distribution comprising at least two peaks configured to transmit light at green and red wavelengths.

10. A light emitting electronic device according to claim 8 or claim 9, comprising at least two such lenses (5) having at least one of a different shape from each other and a different composition of quantum dots (6) from each other.

11. A backlight for a display screen at least comprising a plurality of light emitting electronic devices according to any one of claims 8 to 10.

12. A method of manufacturing a lens, wherein the method at least comprises:
doping a transparent liquid with quantum dots (6) which transmit visible light of a longer wavelength than they receive;
spraying the liquid as droplets (9) from a nozzle (8) of an inkjet printer onto a substrate (10); and
curing the liquid to solidify the droplets.

13. A method according to claim 12, further comprising:
designing a shape of the lens (5); and
depositing the droplets onto the substrate (10) in layers in the shape of the lens as designed.

14. A method according to claim 12 or claim 13, further comprising:
mounting an LED (2) on the substrate (10); and
encapsulating the LED within the lens (5).

15. A method according to any one of claims 12 to 14, further comprising varying one or more of the size, the shape, the composition and the concentration of the quantum dots (6) within the liquid during spraying.
